# EUROPEAN PATENT SPECIFICATION

(11) **EP 2 293 335 B1**
(45) Date of publication and mention of the grant of the patent: **21.03.2012**
(21) Application number: 10162504.4
(22) Date of filing: 11.05.2010
(51) Int. Cl.: H01L 29/778, H01L 29/06, H01L 29/417

(54) **Semiconductor device including a field effect transistor**
Halbleitervorrichtung mit einem Feldeffekttransistor
Dispositif à semi-conducteurs comprenant un transistor à effet de champ

(30) Priority: 08.09.2009 JP 2009207442
(43) Date of publication of application: 09.03.2011
(73) Proprietor: Kabushiki Kaisha Toshiba, Tokyo 105-8001 (JP)
(72) Inventor: Shim, Jeoungchill, Minato-ku Tokyo 105-8001 (JP)
(74) Representative: HOFFMANN EITLE

(56) References cited:
- JP-A- 2006 156 658
- US-A- 5 236 854
- US-A1- 2008 210 977
- US-A1- 2009 194 773

## Description

### FIELD

Embodiments described herein relate generally to a semiconductor device using a compound semiconductor.

### BACKGROUND

A field effect transistor (abbreviated as "an FET") or a high electron mobility transistor (abbreviated as "an HEMT") using a compound semiconductor such as GaN, GaAs, or the like has excellent high frequency characteristics. Therefore, the FET or the HEMT has been widely put to practical use as a semiconductor device which operates in a microwave band. In recent years, higher performance has been demanded for the semiconductor device such as the FET or the HEMT. As a result, a field plate structure has been used in the conventional semiconductor device. Explanation will be made below on a conventional HEMT having a source field plate electrode.

The conventional HEMT has a structure in which a GaN layer and an AlGaN layer are laminated on an SiC substrate. The GaN layer serves as an electron traveling layer whereas the AlGaN layer serves as an electron supplying layer. In addition, a drain electrode and a source electrode are formed on the AlGaN layer wi th a distance therebetween. Moreover, a gate electrode is formed between the drain electrode and the source electrode.

A source field plate electrode is formed on the source electrode in contact with the source electrode. The source field plate electrode extends from a region on the source electrode to the vicinity of the drain electrode via a region on the gate electrode. The source field plate electrode is insulated from the gate electrode via an insulating film.

It is generally known that when a voltage is applied to the gate electrode in the case where no source field plate electrode is formed, a phenomenon that the end of the gate electrode on the side of the drain electrode has a high potential occurs. This signifies that lines of electric force between the gate electrode and the drain electrode cannot be uniformly formed therebetween but is concentrated at the end of the gate electrode on the side of the drain electrode. This causes a decrease in withstand voltage of the HEMT. Moreover, due to the high potential at the end of the gate electrode on the side of the drain electrode, electrons are collected at the end. When the electrons are collected at the end in this manner, the portion at which the electrons are collected also functions similarly to the gate electrode (i.e., a virtual gate effect). As a consequence, a gate length becomes greater than the actual length of the gate electrode, thereby degrading the performance of the HEMT.

However, the source field plate electrode can achieve uniform potential thereunder. As a result, the source field plate electrode acts to achieve uniform distribution of the lines of electric force between the gate electrode and the drain electrode, thus reducing the density of the lines of electric force at the end of the gate electrode on the side of the drain electrode. Thus, the formation of the source field plate electrode can improve the withstand voltage of the HEMT, and further, can suppress the degradation of the performance of the device due to the virtual gate effect. Hence, a HEMT of high performance can be provided by forming the source field plate electrode.

Similarly, in an FET in which a GaN layer is formed on an SiC substrate, and a drain electrode, a source electrode, and a gate electrode are formed on the GaN layer, the performance of the FET can be enhanced by forming a source field plate electrode in the same manner as described above.

However, in semiconductor devices such as the FET or the HEMT in recent years, there is a tendency that the gate length and a distance between the source electrode and the drain electrode are shortened with miniaturization of the device. As a result, a distance between the source field plate electrode and the drain electrode is reduced, and therefore, a stray capacitance generated therebetween becomes large. Moreover, a drain electrode actually fabricated may be formed into a trapezoidal shape having a wide portion in contact with an AlGaN layer. Therefore, the end of the source field plate electrode and the wide portion of the drain electrode overlap via an insulating film, thereby further reducing the distance between the source field plate electrode and the drain electrode. Consequently, a stray capacitance generated between the source field plate electrode and the drain electrode becomes larger. The increase in stray capacitance causes degradation of the performance of the semiconductor device.

In addition, the gate electrode is minute as compared to the source field plate electrode, and therefore, the gate electrode is unfavorably deformed when the source field plate electrode is formed on the gate electrode. Such deformation of the gate electrode also causes the degradation of the performance of the device.

Patent application US 2008/0210977 (Okita) discloses a compound field effect transistor having a double recess in the back surface of the substrate, covered with metal in contact with the source.

### BRIEF DESCRIPTION OF THE DRAWINGS

FIG. 1 is a top view of a semiconductor device according to a first embodiment of the present invention;
FIG. 2 is an enlarged partial cross-sectional view illustrating a cross section of the device taken along an alternate long and short dashed line A-A' of FIG. 1;
FIG. 3 is a cross-sectional view of the device taken along an alternate long and short dashed line B-B' of FIG. 1 ;
FIG. 4 is a top view illustrating a semiconductor device according to a second embodiment of the present invention;
FIG. 5 is an enlarged partial cross-sectional view illustrating a cross section of the device taken along an alternate long and short dashed line A-A' of FIG. 4;
FIG. 6 is a cross-sectional view of the device taken along an alternate long and short dashed line B-B' of FIG. 4;
FIG. 7 is a partial cross-sectional view of a semiconductor device according to a modification of the first embodiment of the present invention taken along the alternate long and short dashed line A-A' of FIG. 1;
FIG. 8 is a partial cross-sectional view of a semiconductor device according to another modification of the first embodiment of the present invention taken along the alternate long and short dashed line A-A' of FIG. 1; and
FIG. 9 is a partial cross-sectional view of a semiconductor device according to another embodiment of the present invention taken along the alternate long and short dashed line A-A' of FIG. 4.

### DETAILED DESCRIPTION

Various embodiments according to the invention will be described hereinafter with reference to the accompanying drawings. In general, according to one embodiment of the present invention, an semiconductor device includes a substrate, a compound semiconductor layer, a device region of a transistor, a drain electrode, a source electrode, a source pad, a gate electrode and a metal. The substrate has a first aperture in a back surface thereof. The compound semiconductor layer is formed on the substrate. The device region is formed on the compound semiconductor layer. The drain electrode is formed transversely to the device region. The source electrode is formed transversely to the device region and with a distance from the drain electrode. The source pad is connected to the source electrode and formed on a non-device region surrounding the device region on the compound semiconductor layer. The gate electrode is formed between the source electrode and the drain electrode, above the first aperture and transversely to the device region. The metal is formed on the back surface of the substrate, including the first aperture and a second aperture penetrating the substrate and the compound semiconductor layer in such a manner as to expose a part of the source pad from the back surface of the substrate. The semiconductor device will specifically be described below with reference to the accompanying drawings.

### (First Embodiment)

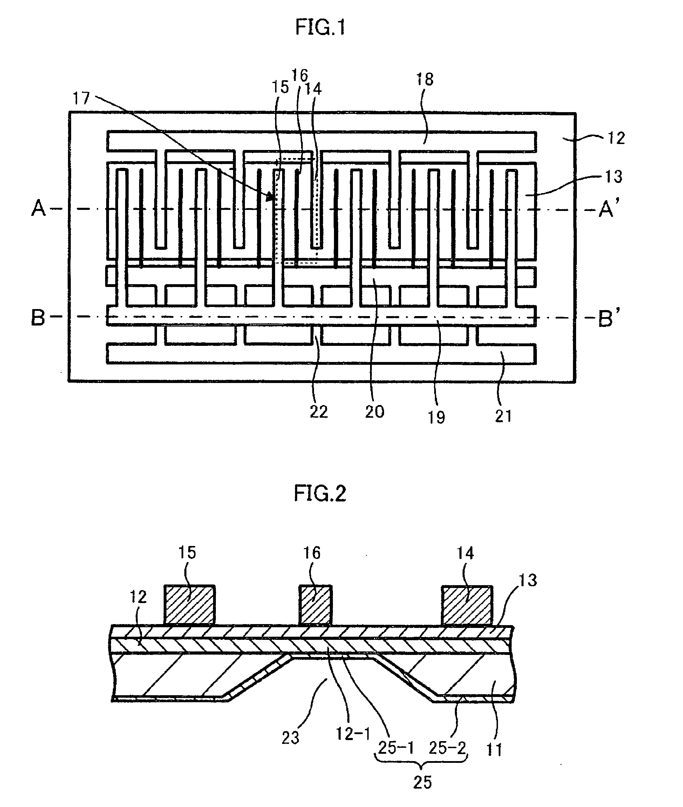

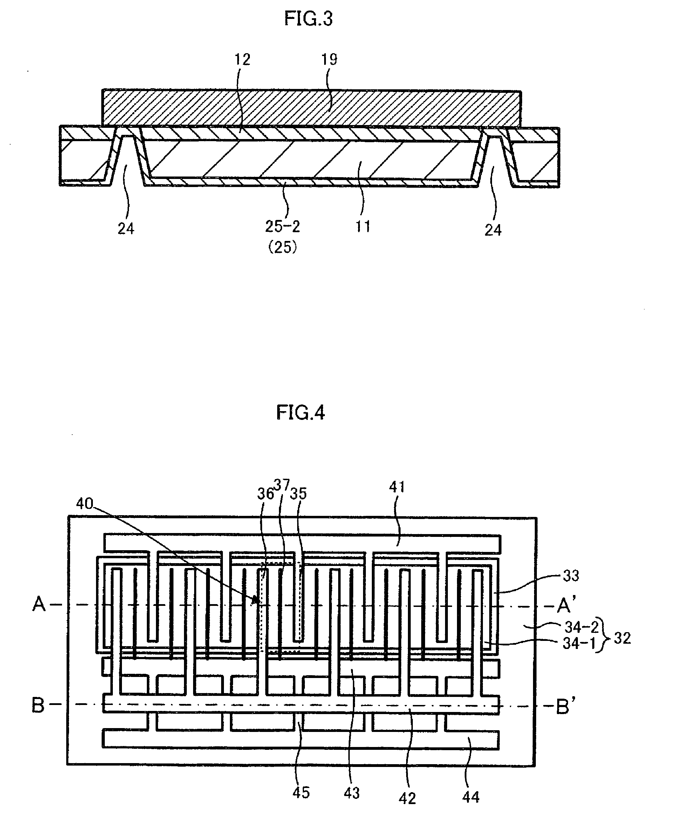

FIG. 1 is a top view of a semiconductor device according to a first embodiment of the present invention. FIG. 2 is an enlarged partial cross-sectional view illustrating a cross section of the semiconductor device taken along an alternate long and short dashed line A-A' of FIG. 1. Furthermore, FIG. 3 is a cross-sectional view of the semiconductor device taken along an alternate long and short dashed line B-B' of FIG. 1.

For example, as illustrated in FIG. 2, a GaN layer 12 is formed on an SiC substrate 11 by epitaxial growth in the semiconductor device according to the present embodiment. The GaN layer 12 serves as an electron traveling layer. An undoped AlGaN layer 13 is formed on a part of the GaN layer 12 similarly by epitaxial growth. The undoped AlGaN layer 13 serves as an electron supplying layer. Alternatively, the AlGaN layer 13 may be an n-doped layer.

The AlGaN layer 13 and the GaN layer 12 under the AlGaN layer 13 serve as a device region, while a portion of the GaN layer 12 surrounding the device region serves as a non-device region. The non-device region is exposed in the present embodiment, but an insulating layer may be formed on the non-device region.

As illustrated in FIG. 1, the AlGaN layer 13 is formed in a belt-like shape. A plurality of belt-like drain electrodes 14 and a plurality of belt-like source electrodes 15 are formed transversely on the belt-like AlGaN layer 13. The drain electrodes 14 and the source electrodes 15 are alternately arranged with a distance therebetween. Each of the drain electrode 14 and the source electrode 15 is made of a metal having, for example, AuGe and Au laminated in this order.

A belt-like gate electrode 16 is formed between each drain electrode 14 and each source electrode 15 transversely on the AlGaN layer 13. The gate electrode 16 is made of a metal having, for example, Ti, Pt, and Au laminated in this order. Therefore, adhesiveness between the gate electrode 16 and the AlGaN layer 13 can be enhanced.

Here, the electrodes 14, 15, and 16 are formed such that the distance between the drain electrode 14 and the gate electrode 16 is greater than that between the source electrode 15 and the gate electrode 16. Consequently, ON resistance can be reduced and withstand voltage can be improved as compared to a semiconductor device in which a gate electrode 16 is formed at the center between a drain electrode 14 and a source electrode 15.

The semiconductor device according to the present embodiment includes a plurality of HEMTs 17, each having the drain electrode 14, the source electrode 15, and the gate electrode 16, arranged in rows.

A drain pad 18, a source pad 19, a gate bus line 20, and a gate pad 21 are formed in a region surrounding the AlGaN layer 13 on the GaN layer 12. Among these components, the drain pad 18 is formed along the AlGaN layer 13. The plurality of drain electrodes 14 are connected to the drain pad 18 . The drain pad 18 is formed integrally with the plurality of drain electrodes 14.

Similarly, the source pad 19 is formed along the AlGaN layer 13 at such a position that the AlGaN layer 13 is interposed between the drain pad 18 and the source pad 19. The plurality of source electrodes 15 are connected to the source pad 19. The source pad 19 is formed integrally with the plurality of source electrodes 15.

The gate bus line 20 is formed between the AlGaN layer 13 and the source pad 19 and along the AlGaN layer 13. The plurality of gate electrodes 16 are connected to the gate bus line 20. The gate pad 21 is formed along the AlGaN layer 13 at such a position that the source pad 19 is interposed between the gate bus line 20 and the gate pad 21. The gate pad 21 and the gate bus line 20 are connected to each other via at least one lead line 22. The gate bus line 20, the gate pad 21, and the lead line 22 are formed integrally with the gate electrodes 16.

Furthermore, as illustrated in FIG. 2, a tapered first aperture 23 is formed under the gate electrode 16 in such a manner as to penetrate the SiC substrate 11. The first aperture 23 may be at least formed such that the gate electrode 16 is fully positioned above a portion 12-1 at which the GaN layer 12 is exposed by the effect of the first aperture 23. The first aperture 23 is formed by dry-etching the SiC substrate 11.

On the other hand, as illustrated in FIG. 3, a plurality of tapered second apertures 24 are formed such that a part of the source pad 19 is exposed from a back surface of the SiC substrate 11. Each of the second apertures 24 is formed in such a manner as to penetrate the SiC substrate 11 and the GaN layer 12. Here, the second apertures 24 are formed by dry etching in the same manner as the first aperture 23, although the first aperture 23 and the second apertures 24 are formed in separate processes.

As illustrated in FIGS. 2 and 3, a metal 25 is deposited on the entire back surface of the SiC substrate 11 having the first aperture 23 and the second apertures 24 formed therein as described above. The metal 25 is, for example, Au.

A portion of the metal 25 deposited on the portion 12-1 at which the GaN layer is exposed in the first aperture 23 functions as a source field plate electrode 25-1, as illustrated in FIG. 2. In general, the withstand voltage of the source field plate electrode 25-1 can be improved as the distance between the gate electrode 16 and the source field plate electrode 25-1 is smaller. In view of this, it is preferable that the above-described first aperture 23 should be formed in such a manner as to penetrate the substrate 11. However, the first aperture 23 need not always penetrate the SiC substrate 11, and may be formed such that a part of the SiC substrate 11 remains as long as the metal 25 functions as the source field plate electrode 25-1. In other words, the first aperture 23 may be a recess formed in the back surface of the SiC substrate 11. In the present specification, the first aperture 23 refers to a through hole penetrating the SiC substrate 11 or a recess formed in the back surface of the SiC substrate 11.

On the other hand, a portion of the metal 25 deposited on the back surface of the SiC substrate 11 and on the side surfaces of the first aperture 23 functions as a ground conductor 25-2. As illustrated in FIG. 3, a portion of the metal 25 deposited on the back surface of the SiC substrate 11 including the second apertures 24 also functions as the ground conductor 25-2. Here, the ground conductor 25-2 is formed in contact with the source pad 19.

A further explanation will be made below on the above-described source field plate electrode 25-1. A conventional source field plate electrode is formed on a gate electrode with a thin insulating film therebetween in order to achieve uniform distribution of lines of electric force between a source electrode and a drain electrode. In this manner, it is possible to reduce the density of the lines of electric force at the end of the gate electrode on the side of the drain electrode.

In contrast, in the semiconductor device according to the present embodiment, the source field plate electrode 25-1 is formed under the gate electrode 16 with the thin GaN layer 12 and the thin AlGaN layer 13 interposed therebetween. Like the conventional source field plate electrode, the source field plate electrode 25-1 acts to achieve uniform distribution of the lines of electric force between the source electrode 15 and the drain electrode 14. As a consequence, the density of the lines of electric force at the end of the gate electrode 16 on the side of the drain electrode 14 is reduced so as to suppress high potential at the end of the gate electrode 16 on the side of the drain electrode 14, thus improving the withstand voltage of the semiconductor device. Moreover, an influence of a virtual gate effect is alleviated, which suppresses degradation of performance of the semiconductor device.

In the semiconductor device according to the present embodiment described above, the source field plate electrode 25-1 is formed on the back surface side of the SiC substrate 11. Consequently, the distance between the drain electrode 14 and the end of the source field plate electrode 25-1 can be increased as compared to the conventional semiconductor device. As a consequence, even if the drain electrode 14 is formed to have a trapezoidal shape in cross section, the distance between the drain electrode 14 and the source field plate electrode 25-1 can be sufficiently increased. Therefore, a stray capacitance generated between the electrodes 14 and 25-1 can be made smaller than that generated in the conventional semiconductor device. Thus, it is possible to suppress the degradation of the performance of the semiconductor device caused by the stray capacitance, so as to achieve the semiconductor device of higher performance.

Additionally, the source field plate electrode 25-1 is formed on the back surface side of the SiC substrate 11, and therefore, the gate electrode 16 can be prevented from being deformed due to the formation of the source field plate electrode 25-1. Thus, it is also possible to prevent the degradation of the performance of the semiconductor device due to the deformation of the gate electrode 16.

In addition, the second apertures 24 penetrating the SiC substrate 11 and the GaN layer 12 are formed under the source pad 19. As a consequence, it is possible to efficiently dissipate heat generated in the source pad 19. Therefore, it is possible to reduce electric resistance in the source pad 19, thus enhancing the heat resistance and ON resistance of the semiconductor device.

### (Second Embodiment)

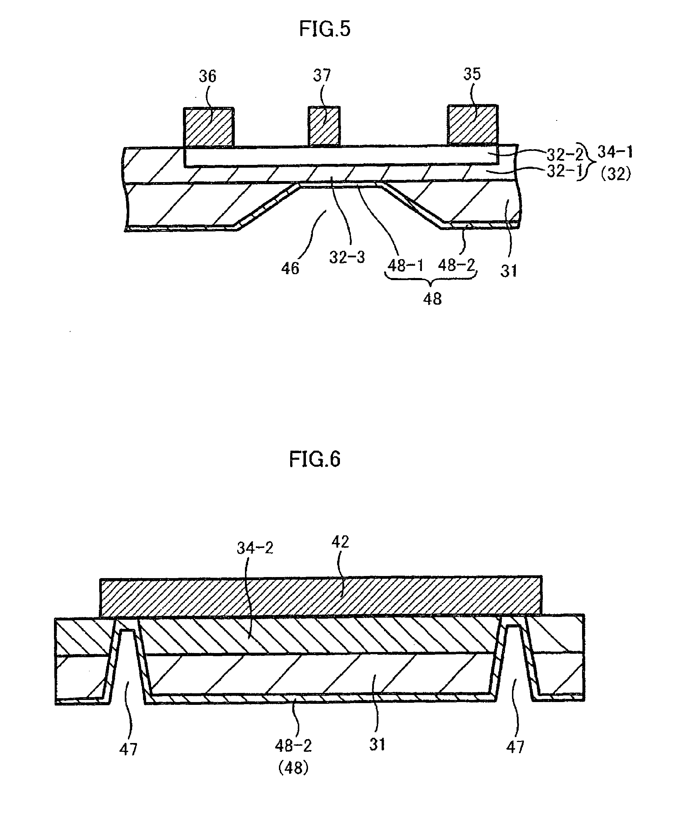

FIG. 4 is a top view of a semiconductor device according to a second embodiment of the present invention. FIG. 5 is an enlarged partial cross-sectional view illustrating a cross section of the semiconductor device taken along an alternate long and short dashed line A-A' of FIG. 4. Furthermore, FIG. 6 is a cross-sectional view of the semiconductor device taken along an alternate long and short dashed line B-B' of FIG. 4.

For example, as illustrated in FIG. 5, a GaN layer 32 is formed on an SiC substrate 31 by epitaxial growth in the semiconductor device according to the present embodiment.

As illustrated in FIG. 4, the GaN layer 32 includes a belt-like device region 34-1 and a non-device region 34-2 surrounding the device region 34-1. The regions 34-1 and 34-2 are separated from each other via a frame-like device separating layer 33.

A plurality of belt-like drain electrodes 35 and a plurality of belt-like source electrodes 36 are formed transversely on the device region 34-1 of the above-described GaN layer 32. The drain electrodes 35 and the source electrodes 36 are alternately arranged with a distance therebetween. Each of the drain electrode 35 and the source electrode 36 is made of a metal having, for example, AuGe and Au laminated in this order.

A belt-like gate electrode 37 is formed between each drain electrode 35 and each source electrode 36 transversely to the device region 34-1. The gate electrode 37 is made of a metal having, for example, Ti, Pt, and Au laminated in this order. Therefore, adhesiveness between the gate electrode 37 and the GaN layer 32 can be enhanced.

The semiconductor device according to the present embodiment includes a plurality of FETs 40, each having the drain electrode 35, the source electrode 36, and the gate electrode 37, arranged in rows.

Referring back to FIG. 5, the device region 34-1 includes a p-type GaN layer 32-1 and an n-type GaN layer 32-2 formed in the surface of the p-type GaN layer 32-1. Out of the two GaN layers, the n-type GaN layer 32-2 is formed for each FET 40. The p-type and n-type GaN layers 32-1 and 32-2 are formed by epitaxially growing a GaN layer, followed by doping p-type ions, and subsequently, doping n-type ions. It is to be noted that the p-type GaN layer 32-1 and the n-type GaN layer 32-2 may be of opposite conductive types.

The drain electrode 35 and the source electrode 36 are formed with a distance therebetween on each of the n-type GaN layers 34-2. The gate electrode 37 is formed between the electrodes 35 and 36.

Here, the electrodes 35, 36, and 37 are formed such that the distance between the drain electrode 35 and the gate electrode 37 is greater than that between the source electrode 36 and the gate electrode 37. Consequently, ON resistance can be reduced and withstand voltage can be improved as compared to a semiconductor device in which a gate electrode 37 is formed at the center between a drain electrode 35 and a source electrode 37.

A drain pad 41, a source pad 42, a gate bus line 43, and a gate pad 44 are formed on the non-device region 34-2. Among these components, the drain pad 41 is formed along the device region 34-1. The plurality of drain electrodes 35 are connected to the drain pad 41. The drain pad 41 is formed integrally with the drain electrodes 35.

Similarly, the source pad 42 is formed along the device region 34-1 at such a position that the device region 34-1 is interposed between the drain pad 41 and the source pad 42. The plurality of source electrodes 36 are connected to the source pad 42. The source pad 42 is formed integrally with the source electrodes 36.

The gate bus line 43 is formed between the device region 34-1 and the source pad 42 and along the device region 34-1. The plurality of gate electrodes 37 are connected to the gate bus line 43. The gate pad 44 is formed along the device region 34-1 at such a position that the source pad 42 is interposed between the gate bus line 43 and the gate pad 44. The gate pad 44 and the gate bus line 43 are connected to each other via at least one lead line 45. The gate bus line 43, the gate pad 44, and the lead line 45 are formed integrally with the gate electrodes 37.

Furthermore, as illustrated in FIG. 5, a tapered first aperture 46 is formed under the gate electrode 37, like in the first embodiment. The first aperture 46 may at least formed such that the gate electrode 37 is fully positioned above a portion 32-3 at which the p-type GaN layer 32-1 is exposed by the effect of the first aperture 46.

On the other hand, as illustrated in FIG. 6, a plurality of tapered second apertures 47 are formed such that parts of the source pad 42 are exposed from a back surface of the SiC substrate 31. Each of the second apertures 47 is formed in the same manner as in the first embodiment.

A metal 48 is deposited in a predetermined thickness on the entire back surface of the SiC substrate 31 having the first aperture 46 and the second apertures 47 formed therein as described above, as illustrated in FIGS. 5 and 6. The metal 48 is, for example, Au.

A portion of the metal 48 deposited on the portion 32-1 at which the GaN layer 32 is exposed in the first aperture 46 functions as a source field plate electrode 48-1, as illustrated in FIG. 5. As described above, the withstand voltage of the source field plate electrode 48-1 can be improved as the distance between the gate electrode 37 and the source field plate electrode 48-1 is smaller. In view of this, it is preferable that the above-described first aperture 46 should be formed in such a manner as to penetrate the SiC substrate 31. However, the first aperture 46 need not always penetrate the SiC substrate 31, and may be formed such that a part of the SiC substrate 31 remains as long as the metal 48 functions as the source field plate electrode 48-1. In other words, the first aperture 46 may be a recess formed in the back surface of the SiC substrate 31. In the present specification, like the first aperture 23, the first aperture 46 refers to a through hole penetrating the SiC substrate 31 or a recess formed in the back surface of the SiC substrate 31.

On the other hand, a portion of the metal 48 deposited on the back surface of the SiC substrate 31 and on the side surfaces of the first aperture 46 functions as a ground conductor 48-2. As illustrated in FIG. 6, the metal 48 deposited on the back surface of the SiC substrate 31 including the second apertures 47 also functions as the ground conductor 48-2. Here, the ground conductor 48-2 is formed in contact with the source pad 42.

According to the semiconductor device of the present embodiment described above, the source field plate electrode 48-1 is formed on the back surface side of the SiC substrate 31. Consequently, the distance between the drain electrode 35 and the source field plate electrode 48-1 can be increased as compared to the semiconductor device having the conventional FETs. As a consequence, even if the drain electrode 35 is formed to have a trapezoidal shape in cross section, the distance between the drain electrode 35 and the source field plate electrode 48-1 can be sufficiently increased. Therefore, a stray capacitance generated between electrodes 35 and 48-1 can be made smaller than that generated in the conventional semiconductor device. Thus, it is possible to suppress the degradation of the performance of the semiconductor device caused by the stray capacitance, so as to achieve the semiconductor device of higher performance.

Additionally, the source field plate electrode 48-1 is formed on the back surface side of the SiC substrate 31, and therefore, the gate electrode 37 can be prevented from being deformed due to the formation of the source field plate electrode 48-1. Thus, it is also possible to suppress the degradation of the performance of the semiconductor device due to the deformation of the gate electrode 37.

In addition, the second apertures 47 penetrating the SiC substrate 31 and the GaN layer 32 are formed under the source pad 42. As a consequence, it is possible to efficiently dissipate heat generated in the source pad 42. Therefore, it is possible to reduce electric resistance of the source pad 42, thus enhancing the heat resistance and ON resistance of the semiconductor device.

Furthermore, in the semiconductor device according to the present embodiment, only the GaN layer 34-1 is formed by the epitaxial growth on the SiC substrate 31. In contrast, in the semiconductor device according to the first embodiment, the GaN layer 12 and the AlGaN layer 13 are formed by the epitaxial growth on the SiC substrate 11. Since the epitaxial growth typically requires much time, shorter time is required for fabricating a semiconductor device as the number of layers subjected to the epitaxial growth is smaller. Therefore, the time required for fabricating the semiconductor device according to the present embodiment can be shortened as compared to that according to the first embodiment, thus reducing the fabrication cost.

While the semiconductor devices according to the embodiments of the present invention have been described above, the present invention is not limited to the above-described embodiments.

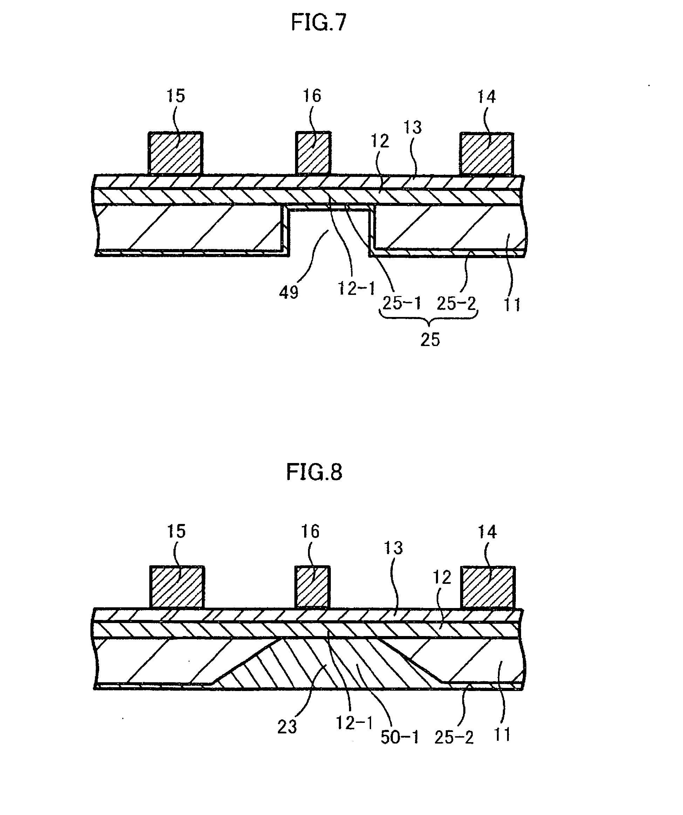

For example, the first apertures 23 and 46 formed in the semiconductor devices of the above-described embodiments need not always be tapered. FIG. 7 is an enlarged partial cross-sectional view illustrating a semiconductor device according to a modification of the first embodiment taken along the alternate long and short dashed line A-A' of FIG. 1. For example, as illustrated in FIG. 7, a first aperture 49 may be formed such that the inside surface thereof is perpendicular to the SiC substrate 11. The first aperture 46 formed in the semiconductor device of the second embodiment may also be formed into the shape as illustrated in FIG. 7.

In addition, the second apertures 24 and 47 formed in the semiconductor devices of the above-described embodiments need not always be tapered, and for example, may be formed into the shape as illustrated in FIG. 7. Moreover, the number of the second apertures 24 and 47 is not limited to two as illustrated in FIGS. 3 and 6.

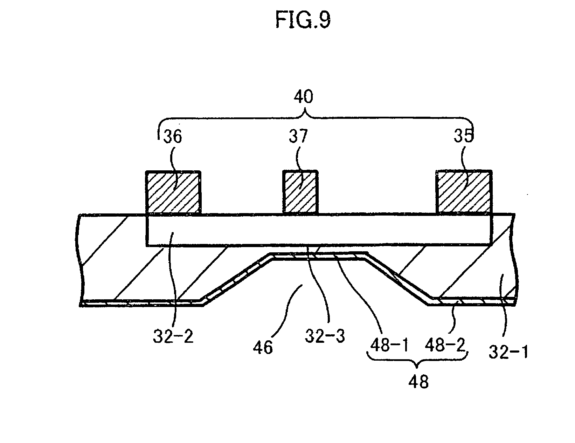

Furthermore, in the semiconductor devices of the above-described embodiments, the thickness of the source field plate electrodes 25-1 and 48-1 formed on the first apertures 23 and 46, respectively, and the thickness of the metals 25 and 48 formed in the second apertures 24 and 47, respectively, are not always limited to such an extent that the source field plate electrodes 25-1 and 48-1 are formed only in parts of the first apertures 23 and 46 and the second apertures 24 and 47, as illustrated in FIGS. 2, 3, 5, and 6. FIG. 8 is an enlarged partial cross-sectional view of a semiconductor device according to another modification of the first embodiment taken along the alternate long and short dashed line A-A' of FIG. 1. For example, as illustrated in FIG. 8, a source field plate electrode 50-1 may have such a thickness as to fill the first aperture 23. The source field plate electrode 48-1 formed in the semiconductor device of the second embodiment and the metals 25 and 48 respectively formed in the second apertures 24 and 47 in the semiconductor device of the first and second embodiments may also have such a thickness as to fill the first aperture 46 and the second apertures 24 and 47, similarly to the case of FIG. 9, for example.

By forming the metals 25 and 48 to have a large thickness, the mechanical strength of the semi conduct or devices can be enhanced. In the case where the metals 25 and 48 are formed to be thick, the metals 25 and 48 may be formed by plating.

In addition, a material making each of the semiconductor devices of the embodiments described above is not limited. For example, a semiconductor device having a GaAs layer as an electron traveling layer and an AlGaAs layer as an electron supplying layer is also applicable to the semiconductor device of the first embodiment in the same manner.

Moreover, the number of FETs 40 or HEMTs 17 in the semiconductor devices of the above-described embodiments is not limited. Therefore, even a semiconductor device including a single FET or HEMT is also applicable in the same manner.

Additionally, the configurations of the FET and the HEMT are not limited to those in the above-described embodiments. A semiconductor device including an FET or an HEMT having a different configuration is also applicable in the same manner.

In addition, the substrate is not limited to the SiC substrates 11 and 31 in the semiconductor devices of the above-described embodiments. A semiconductor device using an Si substrate, an A1 substrate, or a sapphire substrate is also applicable in the same manner.

Furthermore, a semiconductor device in which an FET or an HEMT is formed on a bulk type compound semiconductor layer without using any substrate is also applicable in the same manner. Specifically, as illustrated, for example, in FIG. 9 which is an enlarged view of a cross section of a semiconductor device according to another embodiment taken along the line A-A' of FIG. 4, a device in which the FET 40 is formed on a bulk type GaN layer 32-1 made of p-type GaN is also applicable in the same manner.

## Claims

1. A semiconductor device comprising:
a subsrrate (11) having a first aperture (23) in a back surface thereof;
a compound semiconductor layer (12) formed on the substrate (11);
a device region (13) of a transistor formed on the compound semiconductor layer (12);
a drain electrode (14) formed transversely to the device region (13);
a source electrode (15) formed transversely to the device region (13) and with a distance from the drain electrode (14);
a source pad (19) connected to the source electrode (15) and formed on a non-device region surrounding the device region (13) on the compound semiconductor layer (12);
a gate electrode (16) formed between the source electrode (15) and the drain electrode (14), above the first aperture (23) and transversely to the device region (13); and
a metal (25) formed on the back surface of the substrate (11), including the first aperture (23) and a second aperture (24) penetrating the substrate (11) and the compound semiconductor layer (12) in such a manner as to expose a part of the source pad (19) from the back surface of the substrate (11).

2. The semiconductor device according to claim 1, wherein the first aperture is a through hole penetrating the substrate.

3. The semiconductor device according to claim 1, wherein the first aperture is a tapered opening.

4. The semiconductor device according to claim 1, wherein a side surface of the first aperture is perpendicular to the substrate.

5. The semiconductor device according to claim 1, wherein the first aperture is a recess formed in the back surface of the substrate.

6. The semiconductor device according to claim 1, wherein the second aperture is a tapered opening.

7. The semiconductor device according to claim 1, wherein a side surface of the second aperture is perpendicular to the substrate.

8. The semiconductor device according to claim 1, wherein the metal is formed in a predetermined thickness.

9. The semiconductor device according to claim 1, wherein the metal is formed in such a manner as to at least fill the first aperture.

10. The semiconductor device according to claim 1, wherein the distance between the drain electrode and the gate electrode is greater than that between the source electrode and the gate electrode.

11. The semiconductor device according to claim 10, wherein a plurality of drain electrodes, source electrodes, and gate electrodes are formed on the device region.

12. The semiconductor device according to claim 11, wherein the plurality of drain electrodes and the plurality of source electrodes are alternately arranged.

13. The semiconductor device according to claim 11, wherein
the plurality or drain electrodes are connected to a drain pad formed on the non-device region;
the plurality of source electrodes are connected to the source pad; and
the plurality of gate electrodes are electrically connected to a gate pad formed on the non-device region.

14. The semiconductor device according to claim 1, wherein
the compound semiconductor layer includes an electron traveling layer formed on the substrate, and an electron supplying layer formed on a part of the electron traveling layer in a belt-like manner,
the device region includes the electron supplying layer and the electron traveling layer formed under the electron supplying layer, and
the non-device region includes the electron traveling layer around the electron traveling layer included in the device region.

15. The semiconductor device according to claim 1, wherein the compound semiconductor layer includes a second impurity layer of a second conductive type having a first impurity layer of a first conductive type formed thereon in a belt-like manner,
the device region includes the first impurity layer and the second impurity layer formed under the first impurity layer, and
the non-device region includes the second impurity layer around the first impurity layer.

## Patentansprüche

1. Halbleitervorrichtung, umfassend:
ein Substrat (11) mit einer ersten Öffnung (23) in einer Rückseite davon;
eine Verbindungshalbleiterschicht (12), die auf dem Substrat (11) ausgebildet ist;
einen Vorrichtungsbereich (13) eines Transistors, ausgebildet auf der Verbindungshalbleiterschicht (12);
eine Drain-Elektrode (14), die quer zu dem Vorrichtungsbereich (13) ausgebildet ist;
eine Source-Elektrode (15), die quer zu dem Vorrichtungsbereich (13) und mit einem Abstand von der Drain-Elektrode (14) ausgebildet ist;
ein Source-Pad (19), das mit der Source-Elektrode (15) verbunden ist und auf einem Nicht-Vorrichtungsbereich ausgebildet ist, der den Vorrichtungsbereich (13) auf der Verbindungshalbleiterschicht (12) umgibt;
eine Gate-Elektrode (16), die zwischen der Source-Elektrode (15) und der Drain-Elektrode (14) ausgebildet ist, über der ersten Öffnung (23) und quer zu dem Vorrichtungsbereich (13); und
ein Metall (25), das auf der Rückseite des Substrats (11) ausgebildet ist, umfassend die erste Öffnung (23) und eine zweite Öffnung (24), die das Substrat (11) und die Verbindungshalbleiterschicht (12) in solch einer Weise durchdringt, dass ein Teil des Source-Pads (19) von der Rückseite des Substrats (11) freigelegt wird.

2. Halbleitervorrichtung nach Anspruch 1, wobei die erste Öffnung ein Durchgangsloch ist, das das Substrat durchdringt.

3. Halbleitervorrichtung nach Anspruch 1, wobei die erste Öffnung eine abgeschrägte Öffnung ist.

4. Halbleitervorrichtung nach Anspruch 1, wobei eine Seitenfläche der ersten Öffnung senkrecht zu dem Substrat ist.

5. Halbleitervorrichtung nach Anspruch 1, wobei die erste Öffnung eine Aussparung ist, die in der Rückseite des Substrats ausgebildet ist.

6. Halbleitervorrichtung nach Anspruch 1, wobei die zweite Öffnung eine abgeschrägte Öffnung ist.

7. Halbleitervorrichtung nach Anspruch 1, wobei eine Seitenfläche der zweiten Öffnung senkrecht zu dem Substrat ist.

8. Halbleitervorrichtung nach Anspruch 1, wobei das Metall in einer vorbestimmten Dicke ausgebildet ist.

9. Halbleitervorrichtung nach Anspruch 1, wobei das Metall in solch einer Weise ausgebildet ist, dass es wenigstens die erste Öffnung füllt.

10. Halbleitervorrichtung nach Anspruch 1, wobei die Distanz zwischen der Drain-Elektrode und der Gate-Elektrode größer ist als die zwischen der Source-Elektrode und der Gate-Elektrode.

11. Halbleitervorrichtung nach Anspruch 10, wobei eine Vielzahl von Drain-Elektroden, Source-Elektroden und Gate-Elektroden auf dem Vorrichtungsbereich ausgebildet sind.

12. Halbleitervorrichtung nach Anspruch 11, wobei die Vielzahl von Drain-Elektroden und die Vielzahl von Source-Elektroden abwechselnd angeordnet sind.

13. Halbleitervorrichtung nach Anspruch 11, wobei
die Vielzahl von Drain-Elektroden mit einem Drain-Pad verbunden sind, ausgebildet auf dem Nicht-Vorrichtungsbereich;
die Vielzahl von Source-Elektroden mit dem Source-Pad verbunden sind; und
die Vielzahl von Gate-Elektroden elektrisch mit einem Gate-Pad verbunden sind, das auf dem Nicht-Vorrichtungsbereich ausgebildet ist.

14. Halbleitervorrichtung nach Anspruch 1, wobei
die Verbindungshalbleiterschicht eine Elektronen-Laufschicht (engl.: electron traveling layer) umfasst, die auf dem Substrat ausgebildet ist, und eine Elektronen-Versorgungsschicht (engl.: electron supplying layer), die auf einem Teil der Elektronen-Laufschicht in einer gürtelähnlichen Weise ausgebildet ist,
der Vorrichtungsbereich die Elektronen-Versorgungsschicht und die Elektronen-Laufschicht umfasst, ausgebildet unter der Elektronen-Versorgungsschicht, und
der Nicht-Vorrichtungsbereich die Elektronen-Laufschicht um die Elektronen-Laufschicht umfasst, die in dem Vorrichtungsbereich enthalten ist.

15. Halbleitervorrichtung nach Anspruch 1, wobei die Verbindungshalbleiterschicht eine zweite Störstellenschicht eines zweiten Leitungstyps umfasst, auf der eine erste Störstellenschicht eines ersten Leitungstyps in einer gürtelähnlichen Weise ausgebildet ist,
der Vorrichtungsbereich die erste Störstellenschicht und die zweite Störstellenschicht, die unter der ersten Störstellenschicht ausgebildet ist, umfasst, und der Nicht-Vorrichtungsbereich die zweite Störstellenschicht um die erste Störstellenschicht umfasst.

## Revendications

1. Dispositif à semi-conducteurs comprenant :
un substrat (11) comportant une première ouverture (23) dans une surface arrière de celui-ci ;
une couche semi-conductrice composite (12) formée sur le substrat (11) ;
une région de dispositif (13) d'un transistor formée sur la couche semi-conductrice composite (12) ;
une électrode de drain (14) formée transversalement à la région de dispositif (13) ;
une électrode de source (15) formée transversalement à la région de dispositif (13) et avec une distance par rapport à l'électrode de drain (14) ;
une pastille de source (19) connectée à l'électrode de source (15) et formée sur une région non de dispositif entourant la région de dispositif (13) sur la couche semi-conductrice composite (12) ;
une électrode de grille (16) formée entre l'électrode de source (15) et l'électrode de drain (14), au-dessus de la première ouverture (23) et transversalement à la région de dispositif (13) ; et
un métal (25) formé sur la surface arrière du substrat (11), comprenant la première ouverture (23) et une deuxième ouverture (24) pénétrant dans le substrat (11) et la couche semi-conductrice composite (12) de manière à exposer une partie de la pastille de source (19) de la surface arrière du substrat (11).

2. Dispositif à semi-conducteurs selon la revendication 1, dans lequel la première ouverture est un trou traversant pénétrant dans le substrat.

3. Dispositif à semi-conducteurs selon la revendication 1, dans lequel la première ouverture est une ouverture conique.

4. Dispositif à semi-conducteurs selon la revendication 1, dans lequel une surface latérale de la première ouverture est perpendiculaire au substrat.

5. Dispositif à semi-conducteurs selon la revendication 1, dans lequel la première ouverture est un évidement formé dans la surface arrière du substrat.

6. Dispositif à semi-conducteurs selon la revendication 1, dans lequel la deuxième ouverture est une ouverture conique.

7. Dispositif à semi-conducteurs selon la revendication 1, dans lequel une surface latérale de la deuxième ouverture est perpendiculaire au substrat.

8. Dispositif à semi-conducteurs selon la revendication 1, dans lequel le métal est formé en une épaisseur prédéterminée.

9. Dispositif à semi-conducteurs selon la revendication 1, dans lequel le métal est formé de manière à remplir au moins la première ouverture.

10. Dispositif à semi-conducteurs selon la revendication 1, dans lequel la distance entre l'électrode de drain et l'électrode de grille est supérieure à celle entre l'électrode de source et l'électrode de grille.

11. Dispositif à semi-conducteurs selon la revendication 10, dans lequel une pluralité d'électrodes de drain, d'électrodes de source et d'électrodes de grille sont formées sur la région de dispositif.

12. Dispositif à semi-conducteurs selon la revendication 11, dans lequel la pluralité d'électrodes de drain et la pluralité d'électrodes de source sont agencées de manière alternée.

13. Dispositif à semi-conducteurs selon la revendication 11, dans lequel
la pluralité d'électrodes de drain sont connectées à une pastille de drain formée sur la région non de dispositif ;
la pluralité d'électrodes de source sont connectées à la pastille de source ; et
la pluralité d'électrodes de grille sont connectées électriquement à une pastille de grille formée sur la région non de dispositif.

14. Dispositif à semi-conducteurs selon la revendication 1, dans lequel
la couche semi-conductrice composite comprend une couche de propagation d'électrons formée sur le substrat, et une couche de fourniture d'électrons formée sur une partie de la couche de propagation d'électrons à la manière d'une courroie,
la région de dispositif comprend la couche de fourniture d'électrons et la couche de propagation d'électrons formée sous la couche de fourniture d'électrons, et
la région non de dispositif comprend la couche de propagation d'électrons autour de la couche de propagation d'électrons incluse dans la région de dispositif.

15. Dispositif à semi-conducteurs selon la revendication 1, dans lequel la couche semi-conductrice composite comprend une deuxième couche d'impureté d'un deuxième type de conductivité ayant une première couche d'impureté d'un premier type de conductivité formée sur celle-ci à la manière d'une courroie,
la région de dispositif comprend la première couche d'impureté et la deuxième couche d'impureté formée sous la première couche d'impureté, et
la région non de dispositif comprend la deuxième couche d'impureté autour de la première couche d'impureté.
